# DEMANDE DE BREVET EUROPEEN

(11) **EP 1 860 700 A2**
(43) Date de publication de la demande: **28.11.2007**
(21) Numéro de dépôt: 07009759.7
(22) Date de dépôt: 16.05.2007
(51) Int. Cl.: H01L 27/146, C03C 17/28

(54) **Procédé de traitement d'une surface rayée, notamment une plaque de verre d'un wafer de semi-conducteur**

(30) Priorité: 26.05.2006 FR 0604770
(71) Demandeur: STMicroelectronics (Rousset) SAS, 13790 Rousset (FR); STMicroelectronics S.A., 13106 Rousset cedex (FR)
(72) Inventeur: Hernandez, Caroline, 13860 Peyrolles (FR)
(74) Mandataire: Marchand, André

(57) **Abrégé**

La présente invention concerne un procédé de traitement d'une surface rayée (20') devant laisser passer un rayonnement électromagnétique. Selon l'invention, le procédé comprend une étape de dépôt sur la surface rayée d'au moins une couche (31') d'un matériau polymère (30) ayant sensiblement le même indice optique que le matériau constituant la surface rayée, de façon à colmater les rayures, et une étape de polymérisation du matériau polymère. Application notamment à la fabrication de wafers de semi-conducteur comprenant des imageurs.

## Description

La présente invention concerne le traitement d'une surface rayée et notamment le traitement d'une surface en verre couvrant un wafer de semi-conducteur comprenant des imageurs CMOS.

Les imageurs réalisés selon la technologie CMOS (Complementary Metal Oxide Semiconductor) font actuellement l'objet d'un nombre croissant d'applications en raison de leur faible prix de revient comparativement aux imageurs CCD (Charge Coupled Device). De tels imageurs CMOS étaient initialement utilisés pour réaliser des capteurs d'image à faible résolution et de qualité médiocre (par exemple des caméras web). Aujourd'hui, après un important investissement en recherche et développement, les imageurs CMOS peuvent rivaliser avec les imageurs CCD. La présente invention s'inscrit dans un effort de développement et de perfectionnement de cette technologie d'imageurs visant une baisse des prix de revient à qualité égale.

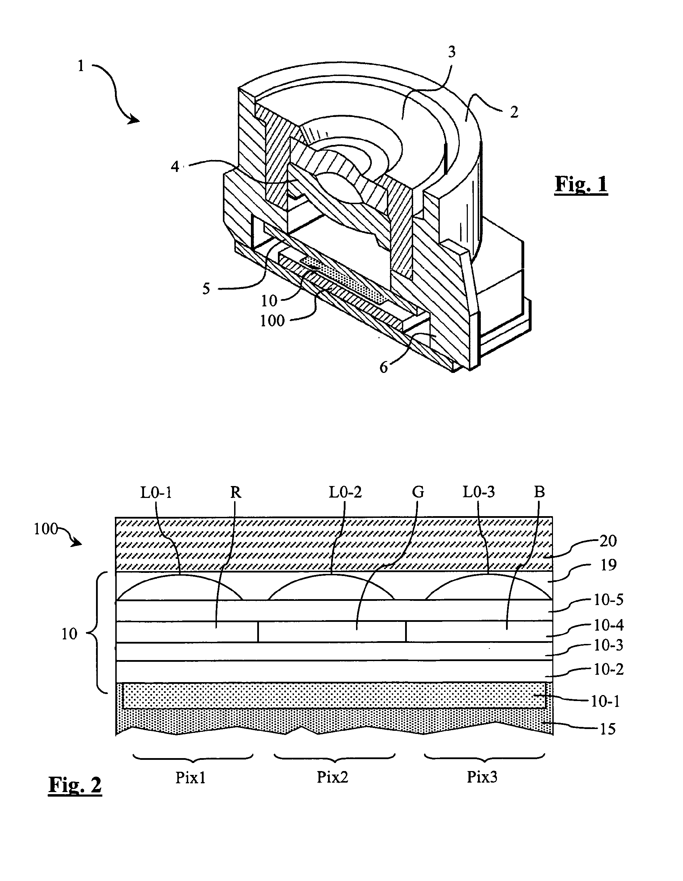

La figure 1 représente un exemple de module de capture d'images et/ou de capture vidéo utilisant un imageur CMOS, destiné par exemple à être monté dans un appareil portatif tel un téléphone mobile, un appareil photographique ou une caméra vidéo. Le module 1 comprend un châssis 2, un bloc optique 3, des lentilles 4 solidaires du bloc 3, un filtre infrarouge 5 et un support 6. Une microplaquette de semi-conducteur 100 intégrant un imageur CMOS 10 est disposée sur le support 6 et reçoit la lumière passant à travers les lentilles et le filtre infrarouge.

L'imageur CMOS 10 comprend des photosites formant chacun un pixel (non visibles sur la figure 1). Chaque pixel comprend une photodiode et un circuit de contrôle et d'interconnexion de la photodiode. Les pixels sont agencés de façon matricielle et une mosaïque de filtres rouges, verts, bleus est répartie au-dessus de la matrice de pixels, généralement selon l'architecture de Bayer.

La figure 2 est une vue en coupe schématique de la microplaquette 100 et de l'imageur CMOS 10 dans une région correspondant à trois pixels PIX1, PIX2, PIX3. On distingue un substrat semi-conducteur 15 dans lequel l'imageur 10 est implanté, et une plaquette de verre 20 fixée sur l'imageur par l'intermédiaire d'une couche de colle 19, par exemple une couche en époxy, uréthane, silicone...

En allant du bas vers le haut, l'imageur 10 comprend des couches 10-1, 10-2, 10-3, 10-4, 10-5 et des microlentilles L0 (L0-1, L0-2, L0-3). La couche 10-1 représente la partie active de l'imageur et comprend des photodiodes et leurs circuits de contrôle et d'interconnexion associés (non détaillés). La couche 10-2 est un matériau diélectrique qui recouvre entièrement le substrat 15. La couche 10-3 est une couche de passivation déposée sur l'imageur en fin de processus de fabrication. La couche 10-4 est formée par des résines colorées et comprend des secteurs R, G, B de couleur rouge, verte ou bleue formant les filtres de couleur primaire susmentionnés, à raison d'un filtre de couleur par pixel. La couche 10-5 est une couche de résine intermédiaire formant un support pour les microlentilles L0 et offrant une bonne planéité (couche de "planarisation"). Les microlentilles L0 sont agencées en une matrice "MLA" (Microlens Array) à raison d'une microlentille par pixel, et sont recouvertes par la couche de colle 19 et par la plaquette de verre 20.

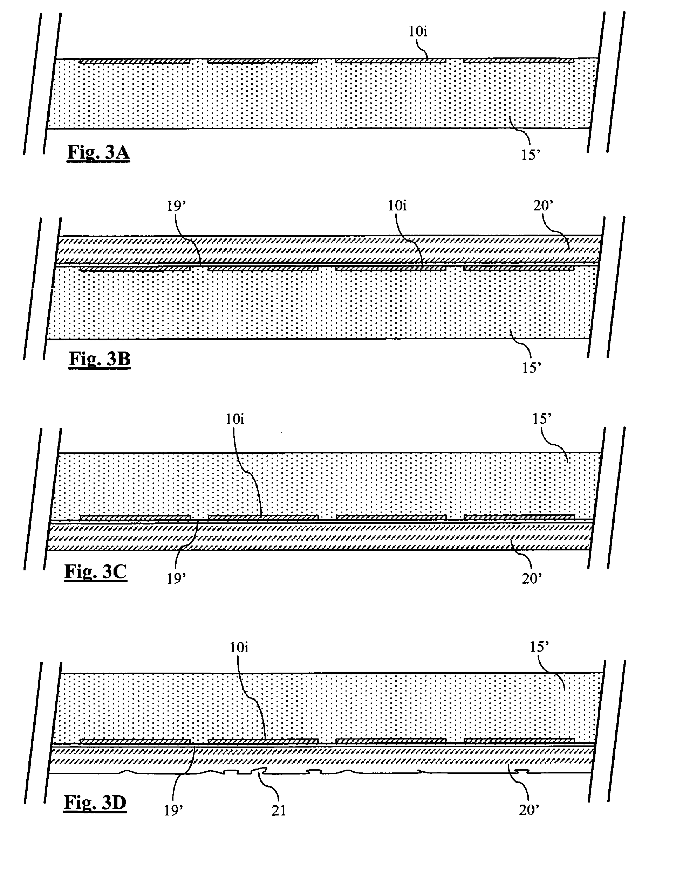

Des étapes d'un procédé de fabrication de la microplaquette 100 sont représentées sur les figures 3A à 3C. Le procédé comprend tout d'abord la fabrication collective d'une pluralité d'imageurs 10i sur un wafer de silicium 15', comme représenté sur la figure 3A. A l'étape illustrée en figure 3B, une grande plaque de verre 20' est fixée sur la face avant du wafer par l'intermédiaire d'une couche de colle 19' recouvrant tout le wafer. A l'étape de la figure 3C et au cours d'étapes suivantes non représentées ici, le wafer 15' est renversé et est posé à l'envers sur la plaque de verre 20', sa face avant orientée vers le haut, pour effectuer un traitement de sa face arrière. Ce traitement en face arrière comprend au moins une étape d'amincissement du wafer par abrasion mécanique (backlapping) de sa face arrière et une étape de sciage du wafer pour obtenir une pluralité de microplaquettes d'imageur comme la microplaquette 100. Le traitement en face arrière peut également comprendre la formation de sillons de prédécoupe, la formation de plages conductrices, la formation de bourrelets conducteurs (bumps), etc.

Au cours de ces diverses étapes où le wafer est posé sur la plaque de verre 20', celle-ci peut subir des frottements qui provoquent des rayures 21 représentées en coupe en figure 3D avec un fort grossissement. Ces rayures peuvent être provoquées par la surface sur laquelle le wafer est posé (chuck). Elles peuvent également être provoquées par des robots (machines de manutention dites de "handling") qui transportent différents équipements intervenant dans le procédé de fabrication, lors du déplacement du panier de wafers vers la "chambre de process".

Ces rayures ne peuvent être acceptées car elles influent directement sur les performances des imageurs. Ainsi une microplaquette d'imageur 100 telle que représentée en figure 2 et dont la face supérieure en verre serait rayée, fournirait des images dans lesquelles les rayures seraient visibles.

Pour pallier cet inconvénient, les solutions généralement retenues sont les suivantes :
- recouvrir la face extérieure de la plaque de verre 20' du wafer d'une couche protectrice en résine avant d'engager la phase de traitement de la face arrière,
- recouvrir les supports et plans de travail avec un matériau protecteur,
- vérifier régulièrement le réglage des robots de manutention, pour éviter les risques de dérèglement qui conduisent ces machines à abîmer les wafers,
- faire en sorte que la face supérieure de la plaque de verre se trouve le plus loin possible du plan focal des lentilles du bloc optique de l'imageur, de manière que les rayures n'apparaissent pas dans les images.

De telles précautions sont généralement combinées et sont donc cumulatives. Toutefois, la solution consistant à déposer une couche protectrice sur la plaque de verre complexifie le processus de fabrication et grève le prix de revient des wafers. De plus, en raison de la fragilité de la couche de protection, cette solution introduit une contrainte supplémentaire en ce qu'elle limite la température utilisable pour le traitement de la face arrière du wafer. Elle limite également le choix des produits chimiques utilisés lors des différentes étapes de traitement (acides, produits corrosifs, etc.). Enfin, la couche protectrice doit être nécessairement retirée avant découpe du wafer, ce qui nécessite une étape de retrait en sus de l'étape de dépôt de cette couche.

La présente invention vise ainsi une alternative à cette solution classique.

La présente invention vise notamment un procédé permettant d'éviter le dépôt et le retrait d'une couche protectrice sur la plaque de verre d'un wafer.

A cet effet, la présente invention se fonde sur une approche du problème technique à résoudre qui constitue en quelque sorte l'antithèse de la solution que l'on veut éviter: au lieu de prévenir l'apparition de rayures en déposant systématiquement une couche protectrice sur chaque wafer en production, la présente invention propose de réparer un wafer abîmé en déposant une couche réparatrice sur sa plaque de verre rayée. En effet, tous les wafers ne sont pas systématiquement abîmés au cours du processus de fabrication et seul un petit nombre de wafers est concerné. Dans ces conditions, il est moins coûteux de réparer un wafer rayé que de faire en sorte qu'aucun wafer ne soit rayé.

Par ailleurs, l'invention propose d'effacer les rayures d'un wafer par colmatage, en déposant sur la surface rayée une couche polymère réparatrice ayant le même indice optique que le verre rayé. Cette solution est simple à mettre en oeuvre et ne nécessite pas d'opération longue et coûteuse comme le serait par exemple une étape d'effacement de rayures par polissage.

La présente invention prévoit ainsi un procédé de traitement d'une surface rayée devant laisser passer un rayonnement électromagnétique, comprenant une étape de dépôt sur la surface rayée d'au moins une couche d'un matériau polymère ayant sensiblement le même indice optique que le matériau constituant la surface rayée, de façon à colmater les rayures, et une étape de polymérisation du matériau polymère.

Dans une application du procédé, la surface rayée est en verre.

Selon un mode de réalisation, la couche de matériau polymère est déposée par enduction centrifuge.

Selon un mode de réalisation, le matériau polymère est choisi dans le groupe comprenant les résines photosensibles ou planarisantes et les colles.

Selon un mode de réalisation, la surface rayée est en un matériau transparent recouvrant un wafer de semi-conducteur.

L'invention concerne également un procédé de fabrication de microplaquettes de semi-conducteur comprenant chacune un composant implanté dans le semi-conducteur, le procédé comprenant une étape d'implantation collective de composants sur une face avant d'un wafer de semi-conducteur, une étape de fixation d'une plaque d'un matériau transparent sur la face avant du wafer, des étapes de traitement du wafer après montage de la plaque de matériau transparent, une étape de découpe du wafer en microplaquettes individuelles et, après les étapes de traitement du wafer et avant sa découpe en microplaquettes, une étape de dépôt d'au moins une couche d'un matériau polymère sur la face externe de la plaque de matériau transparent, le matériau polymère présentant sensiblement le même indice optique que le matériau transparent.

Selon un mode de réalisation, le matériau transparent est du verre.

Selon un mode de réalisation, le procédé comprend une étape de contrôle de la face externe de la plaque de matériau transparent, et l'étape de dépôt de la couche de matériau polymère n'est conduite que si la face externe de la plaque de matériau transparent présente des rayures.

Selon un mode de réalisation, les étapes de traitement du wafer après montage de la plaque de matériau transparent comprennent une étape d'amincissement du wafer par abrasion de sa face arrière.

Selon un mode de réalisation, les étapes de traitement du wafer après montage de la plaque de matériau transparent comprennent des étapes de manipulation du wafer au moyen de machines automatisées.

Selon un mode de réalisation, l'étape d'implantation de composants sur une face du wafer comprend l'implantation d'imageurs destinés à capter des images par l'intermédiaire de la plaque de matériau transparent.

Selon un mode de réalisation, le matériau polymère est choisi dans le groupe comprenant les résines photosensibles ou planarisantes et les colles.

Selon un mode de réalisation, le matériau polymère est une colle utilisée pour fixer la plaque de matériau transparent sur la face avant du wafer.

L'invention concerne également un imageur implanté sur une microplaquette de semi-conducteur, comprenant une plaquette de matériau transparent solidaire de la microplaquette de semi-conducteur par l'intermédiaire de laquelle l'imageur reçoit des images à capter, la face externe de la microplaquette de matériau transparent étant recouverte d'au moins une couche d'un matériau polymère présentant sensiblement le même indice optique que le matériau transparent.

Selon un mode de réalisation, la microplaquette de matériau transparent est en verre.

Selon un mode de réalisation, le matériau polymère appartient au groupe comprenant les résines photosensibles ou planarisantes et les colles.

L'invention concerne également un appareil portatif comprenant un module photographique équipé d'un imageur selon l'invention.

Ces objets, caractéristiques et avantages ainsi que d'autres de la présente invention seront exposés plus en détail dans la description suivante du procédé selon l'invention, faite à titre non limitatif en relation avec les figures jointes parmi lesquelles :
- la figure 1 précédemment décrite représente un module de capture d'image pour appareil portatif,
- la figure 2 précédemment décrite est une vue en coupe schématique d'une microplaquette d'imageur,
- les figures 3A à 3C précédemment décrites représentent des étapes d'un procédé de fabrication collective d'imageurs sur un wafer de silicium, et la figure 3D montre un wafer présentant des rayures,
- les figures 4A à 4E représentent des étapes d'un procédé de fabrication collective d'imageurs sur un wafer de silicium comprenant une étape de traitement de rayures selon l'invention,
- la figure 5 représente une microplaquette d'imageur selon l'invention obtenue après découpe du wafer, et
- la figure 6 représente une variante de réalisation de l'étape de traitement de rayures selon l'invention.

Un exemple de mise en oeuvre du procédé de l'invention sera décrit ici dans le cadre d'un procédé de fabrication d'imageurs sur un wafer de semi-conducteur.

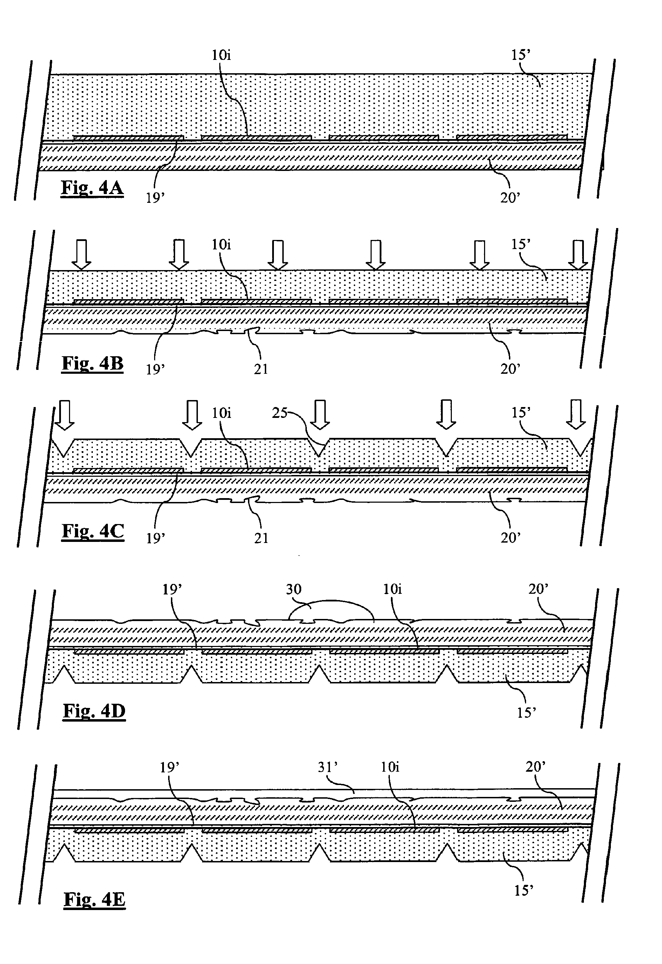

La figure 4A est identique à la figure 3C et montre le wafer 15' précédemment décrit sur lequel une pluralité d'imageurs 10i a été implantée, la face avant du wafer étant recouverte par la plaque de verre 20', fixée au moyen de la couche de colle 19'. Le wafer est posé à l'envers sur une surface de travail (non représentée) pour procéder à des étapes de traitement illustrée en figures 4B et 4C.

L'étape représentée en figure 4B consiste en un meulage et un polissage (backlapping) de la face arrière du wafer afin de réduire son épaisseur, initialement de l'ordre de quelques centaines de micromètres et de l'ordre de quelques dizaines ou d'une centaine de micromètres en fin de processus.

L'étape représentée en figure 4C consiste à pratiquer des rainures ou sillons 25 (grooves) sur la face arrière du wafer. Ces sillons peuvent être prévus pour diverses raisons, par exemple pour faciliter la découpe ultérieure du wafer ou pour réaliser des contacts sur la face arrière. Les sillons 25 sont généralement réalisés par gravure chimique ou gravure au plasma.

Selon l'invention, aucune couche de protection n'est déposée sur la face externe de la plaque de verre 20', qui se trouve donc exposée à un risque de rayures pendant l'étape de la figure 4B ou pendant l'étape de la figure 4C, ou encore pendant des étapes de manutention intervenant avant ou après chacune de ces étapes.

Selon l'invention, une inspection visuelle du wafer est effectuée au terme de l'étape de la figure 4C, ou après une étape de manutention du wafer intervenant après l'étape de la figure 4C, avant que le wafer ne soit scié pour obtenir des microplaquettes d'imageur.

Si la plaque de verre présente des rayures, comme cela est représenté ici sur les figures 4B et 4C, une couche réparatrice en matériau polymère durcissable ayant sensiblement le même indice optique que le verre est déposée sur la plaque de verre pour effacer les rayures. Afin d'obtenir une couche uniforme, le dépôt est de préférence effectué par enduction centrifuge (spin coating). Le matériau déposé peut être liquide ou gélatineux. Il est ensuite polymérisé suivant les conditions requises (polymérisation aux UV ou polymérisation thermique).

Ainsi, à l'étape représentée en figure 4D, une petite quantité de matériau polymère 30, de l'ordre de quelques millilitres, est déposée sur la plaque de verre 20', de préférence au centre du wafer. A l'étape représentée en figure 4E, le matériau 30 est étalé sur toute la surface de la plaque de verre 20' par centrifugation. La vitesse de rotation du wafer est assez faible, par exemple 1500 tr/min. Une forte accélération, par exemple jusqu'à 20000 tr/min est ensuite appliquée au wafer pour favoriser la formation d'une couche uniforme 31' sur toute la surface de la plaque de verre tout en éliminant le surplus de matériau polymère . La vitesse de rotation est ensuite stabilisée à une valeur plus basse, par exemple de l'ordre de 2000 à 7000 tr/mn, afin de définir l'épaisseur de la couche de matériau polymère étalée. La rotation est encore maintenue un certain temps pour permettre l'évaporation du solvant. L'évaporation du solvant diminue sensiblement la viscosité du matériau polymère dont dépend directement l'épaisseur du film. L'évaporation étant rapide, il est nécessaire de veiller à ce que le délai d'étalement du matériau polymère soit court. Durant la rotation à grande vitesse, la plus grande partie du solvant contenu dans le matériau s'évapore pour finir par produire un film solide.

Une étape de cuisson est conduite après l'étape de centrifugation. Cette étape assure l'élimination rapide des solvants résiduels et la polymérisation de la couche réparatrice 31' et est fonction du matériau utilisée. Il s'ensuit une contraction (retrait volumique) du matériau polymère, qui engendre une perte d'épaisseur de l'ordre de la fraction de pourcent à quelques pourcents, selon le matériau utilisé.

Le wafer est par exemple chauffé au moyen de plaques chauffantes portées à une température de l'ordre de la centaine à quelques centaines de degrés (100-300°C en général). La durée du cycle de chauffage est ajustée pour atteindre le taux de solvant désiré, et peut être de quelques minutes à plus d'une heure. La cuisson est suivie d'une étape de refroidissement du wafer, par exemple au moyen de plaques à température ambiante.

Comme alternative, et selon le matériau retenu, l'étape de polymérisation peut également être conduite en exposant le wafer à un rayonnement UV. La polymérisation aux UV est généralement plus courte que la polymérisation thermique et ne dure que quelques minutes au maximum.

L'homme de l'art notera que l'invention peut être mise en oeuvre avec tout type de matériau polymère pouvant être déposé sous forme liquide, puis durci, notamment les résines photosensibles (par exemple les résines "CT" utilisées pour la fabrication des microlentilles des imageurs), les résines "planarisantes" (utilisées pour former des surfaces planes en microélectronique), les résines de couleur, etc. Des essais à la portée de l'homme de l'art permettent de sélectionner les matériaux les plus appropriés en fonction de la nature et des propriétés optiques du verre utilisé.

Des colles peuvent également être utilisées, et de façon générale toute colle pouvant être polymérisée en présence d'un rayonnement UV ou en présence de chaleur. Le matériau est choisi en fonction de ses caractéristiques optiques et doit présenter sensiblement le même indice optique que le matériau rayé pour neutraliser l'apparition d'un dioptre d'interface là où se trouvent les rayures.

Selon un aspect avantageux de l'invention, le matériau utilisé pour réparer les rayures est identique à celui utilisé pour coller la plaque de verre sur le wafer. La colle commercialisée sous la référence OGR150THTG par la société Ablestick est un exemple de colle pouvant être utilisée à cet effet. Dans ce cas, un même équipement permet à la fois de conduire l'étape de collage de la plaque de verre et l'étape de réparation des rayures. Le coût de mise en oeuvre du procédé selon l'invention est alors minimal.

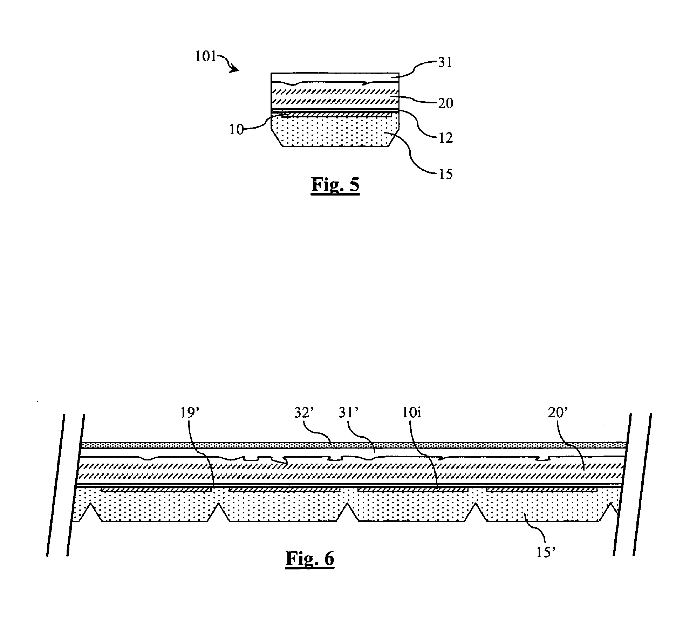

Comme représenté sur la figure 5, une microplaquette d'imageur 101 selon l'invention, obtenue par découpe du wafer, se distingue de la microplaquette classique 100 représentée en figure 2 par la présence d'une couche réparatrice 31 sur la face externe de sa plaquette de verre 20.

Il apparaîtra clairement à l'homme de l'art que le procédé selon l'invention est susceptible de diverses applications et variantes de réalisation. Comme montré sur la figure 6, au moins une seconde couche réparatrice 32' peut être déposée sur le wafer après dépôt de la première couche réparatrice 31'.

Le procédé selon l'invention est applicable à tous dispositifs optiques actifs ou passifs et notamment aux capteurs d'images numériques embarqués dans des appareils portatifs comprenant un module photographique du type représenté en figure 1, notamment les téléphones mobiles, les appareils photographiques et les caméras vidéo.

De plus, bien que le procédé selon l'invention ait été décrit dans ce qui précède en relation avec la fabrication d'un wafer de semi-conducteur comprenant une plaque de verre, l'invention est applicable à tout matériau transparent, notamment du plexiglas, susceptible de remplacer le verre.

Le procédé selon l'invention est également applicable au traitement de tous types de surfaces rayées destinées à laisser passer un rayonnement électromagnétique, soit dans le visible comme dans l'exemple décrit plus haut, soit dans l'infrarouge ou dans l'ultraviolet (voire au-delà), y compris des surfaces filtrantes ne laissant passer qu'un rayonnement électromagnétique ayant certaines longueurs d'ondes.

## Revendications

1. Procédé de traitement d'une surface rayée (20') devant laisser passer un rayonnement électromagnétique, **caractérisé en ce qu'**il comprend une étape de dépôt sur la surface rayée d'au moins une couche (31') d'un matériau polymère (30) ayant sensiblement le même indice optique que le matériau constituant la surface rayée, de façon à colmater les rayures, et une étape de polymérisation du matériau polymère.

2. Procédé selon la revendication 1, dans lequel la surface rayée est en verre.

3. Procédé selon l'une des revendications 1 et 2, dans lequel la couche de matériau polymère est déposée par enduction centrifuge.

4. Procédé selon l'une des revendications 1 à 3, dans lequel le matériau polymère est choisi dans le groupe comprenant les résines photosensibles ou planarisantes et les colles.

5. Procédé selon l'une des revendications 1 à 4, dans lequel la surface rayée est en un matériau transparent recouvrant un wafer de semi-conducteur.

6. Procédé de fabrication de microplaquettes de semi-conducteur (100) comprenant chacune un composant (10) implanté dans le semi-conducteur, comprenant:
- une étape d'implantation collective de composants (10i) sur une face avant d'un wafer de semi-conducteur (15'),
- une étape de fixation d'une plaque d'un matériau transparent (20') sur la face avant du wafer,
- des étapes de traitement du wafer après montage de la plaque de matériau transparent (fig. 4B, 4C), et
- une étape de découpe du wafer en microplaquettes individuelles,
**caractérisé en ce qu'**il comprend, après les étapes de traitement du wafer et avant sa découpe en microplaquettes, une étape de dépôt d'au moins une couche (31') d'un matériau polymère (30) sur la face externe de la plaque de matériau transparent (20), le matériau polymère présentant sensiblement le même indice optique que le matériau transparent.

7. Procédé selon la revendication 6, dans lequel le matériau transparent est du verre.

8. Procédé selon l'une des revendications 6 et 7, comprenant une étape de contrôle de la face externe de la plaque de matériau transparent (20'), et dans lequel l'étape de dépôt de la couche de matériau polymère n'est conduite que si la face externe de la plaque de matériau transparent présente des rayures (21).

9. Procédé selon l'une des revendications 6 à 8, dans lequel les étapes de traitement du wafer après montage de la plaque de matériau transparent (20') comprennent une étape d'amincissement du wafer par abrasion de sa face arrière (fig. 4B).

10. Procédé selon l'une des revendications 6 à 9, dans lequel les étapes de traitement du wafer après montage de la plaque de matériau transparent (20') comprennent des étapes de manipulation du wafer au moyen de machines automatisées.

11. Procédé selon l'une des revendications 6 à 10, dans lequel l'étape d'implantation de composants sur une face du wafer comprend l'implantation d'imageurs (10i) destinés à capter des images par l'intermédiaire de la plaque de matériau transparent (20').

12. Procédé selon l'une des revendications 6 à 11, dans lequel le matériau polymère est choisi dans le groupe comprenant les résines photosensibles ou planarisantes et les colles.

13. Procédé selon l'une des revendications 6 à 12, dans lequel le matériau polymère est une colle utilisée pour fixer la plaque de matériau transparent (20') sur la face avant du wafer.

14. Imageur (101) implanté sur une microplaquette de semi-conducteur, comprenant une plaquette de matériau transparent (20) solidaire de la microplaquette de semi-conducteur par l'intermédiaire de laquelle l'imageur reçoit des images à capter, **caractérisé en ce que** la face externe de la microplaquette de matériau transparent (20) est recouverte d'au moins une couche (31) d'un matériau polymère présentant sensiblement le même indice optique que le matériau transparent.

15. Imageur selon la revendication 14, dans lequel la microplaquette de matériau transparent est en verre.

16. Imageur selon l'une des revendications 14 et 15, dans lequel le matériau polymère appartient au groupe comprenant les résines photosensibles ou planarisantes et les colles.

17. Appareil portatif, **caractérisé en ce qu'**il comprend un module photographique équipé d'un imageur selon l'une des revendications 14 à 16.
